Europäisches Patentamt

European Patent Office

Office européen des brevets

(11) Publication number: **0 283 276**
**A2**

# (12) EUROPEAN PATENT APPLICATION

(21) Application number: 88302312.9

(22) Date of filing: 17.03.88

(51) Int. Cl.⁴: **H 01 L 29/80**
**H 01 L 29/205**

(30) Priority: 20.03.87 JP 64171/87

(43) Date of publication of application:
21.09.88 Bulletin 88/38

(84) Designated Contracting States: **DE FR GB**

(71) Applicant: FUJITSU LIMITED
1015, Kamikodanaka Nakahara-ku
Kawasaki-shi Kanagawa 211 (JP)

(72) Inventor: Awano, Yuji
Haishitil Omotesando 312 14-13, Jingumae 4-chome
Shibuya-ku Tokyo 150 (JP)

Asai, Satoru
Howaitohausu Isehara 202 11-22, Sakuradai 2-chome
Isehara-shi Kanagawa 259-11 (JP)

(74) Representative: Billington, Lawrence Emlyn et al
HASELTINE LAKE & CO Hazlitt House 28 Southampton
Buildings Chancery Lane
London WC2A 1AT (GB)

(54) Semiconductor device having heterojunction and method for producing same.

(57) A semiconductor device includes a heterojunction semi-conductor layer (42, 48) formed on a substrate (41); two electrodes (43, 44) formed on the heterojunction semiconductor layer; and a plurality of control electrodes (45, 49) arranged at predetermined positions between the two electrodes at a predetermined spacing.

A portion of each of the control electrodes (45, 49) is embedded so that the portion is in direct contact with a section of the heterojunction semiconductor layer (42, 48), thereby realizing a better controllability as a transistor. Also, the movement of the carriers is made one-dimensional in the vicinity of the control electrodes (42C, 48B), by both, a thin undoped semiconductor layer in the heterojunction semiconductor layer and a ga defined by each of the plurality of control electrodes (45, 49), thereby enabling a high speed operation.

Fig. 4

EP 0 283 276 A2

## Description

SEMICONDUCTOR DEVICE HAVING HETEROJUNCTION AND METHOD FOR PRODUCING SAME

The present invention relates to a semiconductor device and a method for producing the device. More particularly, it relates to a structure of a transistor having a heterojunction.

As a semiconductor device having a heterojunction structure, a high electron mobility transistor (HEMT) is widely known. The HEMT includes a structure wherein an undoped semiconductor layer and a doped semiconductor layer are in contact with each other, and at the interface of these semiconductor layers, electrons are accumulated to form a kind of layer defined as a two-dimensional electron layer or gas (2 DEG). In operation, electrons travel within the 2 DEG from a source toward a drain without being scattered by impurity ions, and as a result, a very high electron mobility can be obtained. In the known HEMT, the movement of electrons is realized in a two-dimensional direction.

Preferably, however, the structure wherein the movement of electrons occurred in a one-dimensional direction is desired. Theoretically, it has been proved that a device using a one-dimensional electron layer or gas (1 DEG) would show a higher operation speed than that using a 2 DEG, and such a device is disclosed, for example, in p.p. 251 - 256, of a Paper presented at the Int. Symp., GaAs and Related Compounds, Japan, 1981.

The device disclosed in the above Paper has a metal/insulation/semiconductor (MIS) structure and employs gallium arsenide (GaAs) as the semiconductor. This structure, however, brings a number of drawbacks to the device, for example, unsatisfactory gate control, reduction of operation speed, and the like, which will be described later.

Another known semiconductor device realizing a high speed operation, other than the HEMT, is a permeable base transistor (PBT). A PBT includes a structure wherein a fine slit-shaped metal grid is embedded in a layer of a single crystal such as GaAs and the flow of carriers passing through gaps of the metal grid is controlled by applying a controlled voltage to the metal grid. Such a PBT is disclosed, for example, in U.S.P. 4,378,629, wherein carriers travel from an emitter toward a collector in a "vertical" direction. This kind of PBT is hereinafter referred to as a "vertical type or structure" PBT.

A problem arises in the production process of the vertical type PBT in that, in the middle stage of the process, when a semiconductor wafer on which PBTs are being formed is taken out of a vacuum atmosphere and exposed to an open atmosphere, impurities such as carbon (C), oxygen (O) and the like remain on the surface of the semiconductor due to the process carried out at this middle stage. These impurities cause a deterioration in the performance of the device, or difficulties in the control of the pinch-off voltage of the PBT. The problem in the vertical type PBT will be explained later.

As still another semiconductor device realizing high speed operation, a so-called "horizontal type or structure" PBT has been proposed. Such a PBT includes a structure wherein a fine metal grid is embedded in the vertical direction in a single-crystalline layer and carriers travel through gaps of the metal grid in the "horizontal" direction. The structure of the horizontal type PBT makes it possible to prevent the surface of the semiconductor from being contaminated by impurities in the course of the production process, and thus the above problem of the vertical type PBT can be solved. Nevertheless, if possible, a device realizing a much higher speed operation is desired. A device having a structure similar to that of the horizontal type PBT is disclosed, for example, in Japanese Unexamined Patent Publication (Kokai) No. 62-2666.

An embodiment of the present invention may provide a semiconductor device capable of realizing a higher speed operation without lowering the controllability thereof as a transistor.

An embodiment of the present invention may provide a method for producing the device.

The present invention utilises the idea of combining the structure of an HEMT and the structure of a "horizontal type" PBT.

Therefore, according to one aspect of the present invention, there is provided a semiconductor device comprising: a heterojunction semiconductor layer formed on a substrate, having a structure including an undoped semiconductor layer sandwiched between two doped semiconductor layers; two electrodes formed opposite to each other on the heterojunction semiconductor layer; and a plurality of control electrodes arranged at predetermined positions between the two electrodes at a predetermined spacing, a portion of each control electrode being embedded in such a manner that the portion is in direct contact with a section of the heterojunction semiconductor layer, whereby the direction of the movement of carriers within the undoped semiconductor layer is made one-dimensional in the vicinity of the control electrodes.

Also, according to another aspect of the present invention, there is provided a method for producing a semiconductor device comprising the steps of: growing a heterojunction semiconductor layer on a substrate, said heterojunction semiconductor layer comprising a structure including an undoped semiconductor layer sandwiched between doped semiconductor layers; forming two electrodes opposite to each other on the heterojunction semiconductor layer; and embedding a plurality of control electrodes at predetermined positions between the two electrodes at a predetermined spacing in such a manner that a portion of each control electrode is in direct contact with a section of the heterojunction semiconductor layer, whereby the direction of the movement of carriers is made one-dimensional in the vicinity of the control electrodes.

Furthermore, according to still another aspect of the present invention, there is provided a method wherein the step of embedding a plurality of control electrodes is carried out prior to the step of forming the two electrodes.

Reference is made, by way of example, to the accompanying drawings, in which:

Figs. 1a and 1b are views illustrating an example of a typical HEMT, where Fig. 1a is a sectional view and Fig. 1b is an energy band diagram taken along the line B-B in Fig. 1a;

Fig. 2 is a perspective view illustrating an example of an FET using a one-dimensional electron layer;

Fig. 3 is a perspective view, with portions broken away for clarity, illustrating an example of a vertical type PBT;

Fig. 4 is a perspective view, with portions broken away for clarity, illustrating a PB-HEMT as an embodiment of the present invention;

Fig. 5 is a sectional view taken along the line A-A in Fig. 4;

Figs. 6a to 6i are views illustrating a production process of the PB-HEMT shown in Fig. 4; and

Fig. 7 is a sectional view, corresponding to the sectional view in Fig. 5, of a modification of the PB-HEMT shown in Fig. 4.

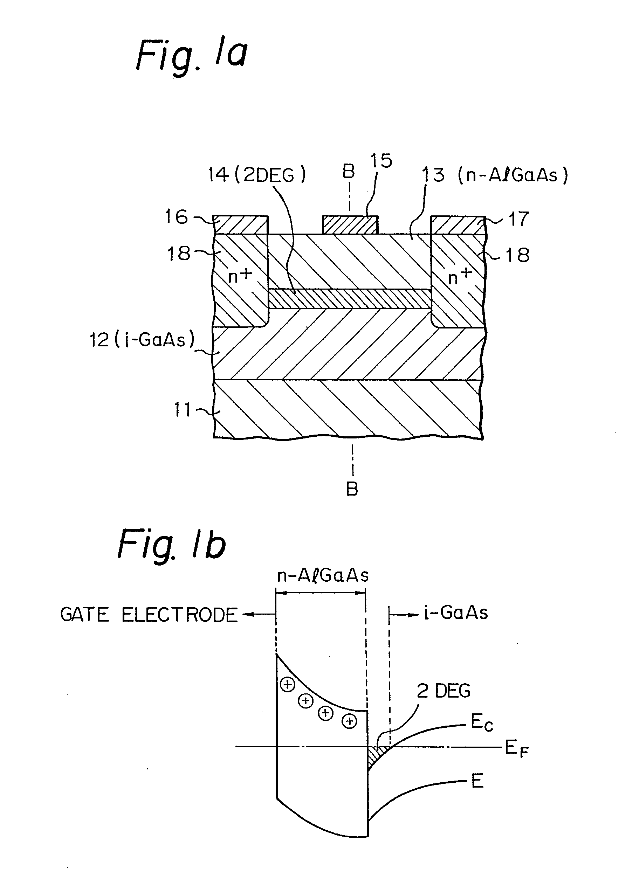

For a better understanding of a preferred embodiment of the present invention, the problems of previous proposals will now be explained with reference to Figs. 1 to 3.

Figures 1a and 1b show an example of a typical HEMT; wherein Fig. 1a shows a section thereof and Fig. 1b shows an energy band taken along the line B-B in Fig. 1a. In Fig. 1a, 11 denotes a substrate; 12 and 13 denote semiconductor layers; 14 denotes a two-dimensional electron layer or gas (2 DEG); 15, 16, and 17 denote electrodes; and 18 denotes an alloyed region. As shown in Fig. 1a, an HEMT is characterized in that semiconductor layers 12 and 13 are in heterocontact with each other, and that only one thereof, i.e., semiconductor layer 13 in the illustrated example, is selectively doped to form an n-type layer. In this structure, free electrons emitted from n-type dopants contained in the semiconductor layer 13 of n-AlGaAs are drawn into the semiconductor layer 12 of i-GaAs, because the electron affinity in GaAs is higher than that in AlGaAs, and as a result, electrons are accumulated in the interface of the layers 12 and 13 to form the 2 DEG.

This HEMT structure can realize a very high electron mobility, because impurity atoms or ions are not introduced into the semiconductor layer 12 of i-GaAs and, accordingly, electrons within the 2 DEG travel along the interface in the side of the semiconductor layer 12 from the source electrode 16 toward the drain electrode 17 without being scattered by the impurity atoms or ions. Thus, the movement of electrons is realized along a plane parallel to the 2 DEG 14, i.e., in a two-dimensional direction.

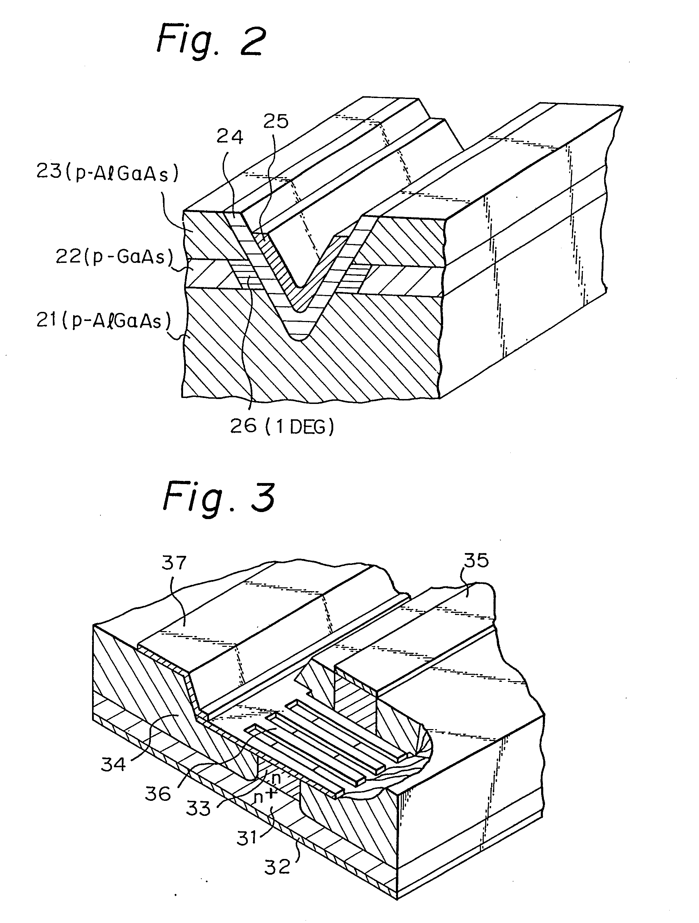

However, as described before, it has been theoretically proved that a device using a 1 DEG would show a higher operation speed than that using a 2 DEG. As an example of a device using a 1 DEG, an FET employing an inversion layer as the 1 DEG is shown in Fig. 2.

In Fig. 2, 21 and 23 denote semiconductor layers of p-AlGaAs; 22 denotes a semiconductor layer of p-GaAs; 24 denotes an insulation layer; 25 denotes a metal layer constituting a gate; and 26 denotes an n-type inversion layer constituting 1 DEG. The FET shown in Fig. 2 has an MIS structure and employs GaAs as the semiconductor, and thus does not constitute a good MISFET from the viewpoint of gate controllability, as hereinafter described.

When the surface of the GaAs layers is exposed to the open atmosphere during the middle stage of the production process, impurities adhere to and remain on the surface thereof. In general, impurities adhere more easily to GaAs than Si. When the insulation layer 24 is then formed, the atoms therein and the remaining impurities interfere with each other, resulting in an unsatisfactory gate control as a transistor. Also, since electrons within the n-type inversion layer 26 travel from a source (not shown) toward a drain (not shown) along the interface in the vicinity of the region where p-type impurity ions exist, they are scattered by the impurity ions and the above remaining impurities, and therefore, the high speed operation or high frequency characteristics are deteriorated. Furthermore, the GaAs layer 22 and AlGaAs layers 21 and 23 are etched into a V-shape, and the etching is carried out by utilizing the dependency of a face orientation of a GaAs wafer with respect to wet etching. Thus, the controllability of the etching is not good or not practical.

Figure 3 illustrates an example of a vertical type PBT, in perspective, with portions broken away for clarity. In Fig. 3, 31 and 33 denote semiconductor layers of n-GaAs; 35 denotes a collector electrode; 34 denotes an insulation layer; 32 denotes an emitter electrode; 36 denotes a base electrode embedded in a crystalline growth layer; and 37 denotes a common electrode for connecting the base electrode 36 to the external. In the vertical type PBT shown in Fig. 3, when a controlled voltage is applied to the common electrode 37, the expansion of the region of a depletion layer in the vicinity of a metal grid of the base electrode 36 is changed, and by controlling this change, the flow of electrons moving from the emitter electrode 32 through gaps of the metal grid toward the collector electrode 35 in a "vertical direction" can be controlled.

However, the production process of the vertical type PBT as shown in Fig. 3 must include the following steps; first, growing the semiconductor layers 31 and 33 halfway in the vacuum state; second, taking the grown semiconductor layers out of the vacuum atmosphere, i.e., placing in the open atmosphere, and carrying out ion implantation for forming the insulation layer 34, patterning for forming the base electrode 36 and common electrode 37, metal deposition, and the like; third, growing the remaining portions of the semiconductor layers again in the vacuum state. Therefore, when the semiconductor is exposed to an open atmosphere, impurities such as carbon, oxygen and the like remain on the surface of the semiconductor due to the processes of ion implantation, patterning, metal deposition, and the like, and as a result, problems arise in that the performance of the device, e.g., high speed operation and high frequency characteristics, is deteriorated and control of the pinch-off voltage of the transistor becomes difficult.

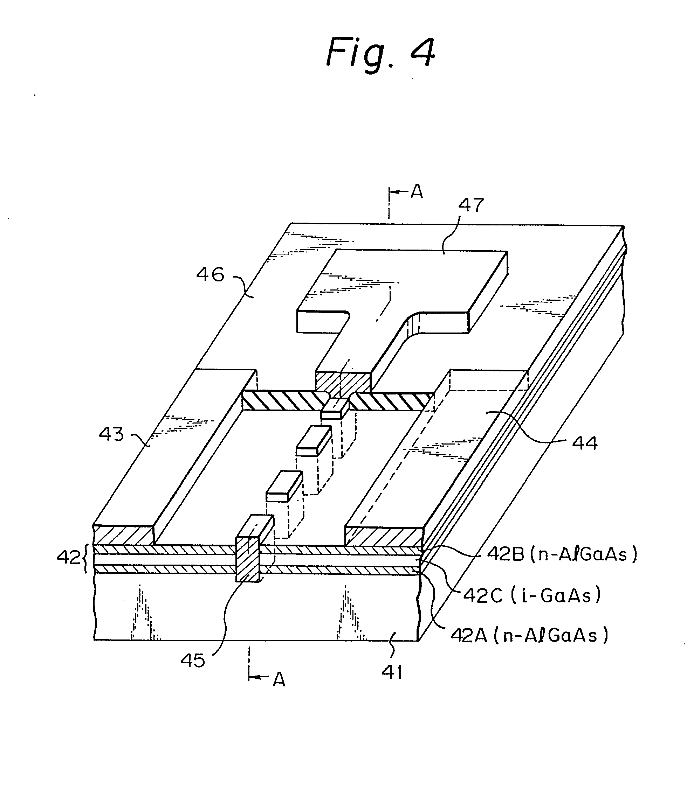

Preferred embodiments of the present invention will now be described in detail with reference to Figs. 4 to 7.

Figure 4 illustrates a permeable base high electron mobility transistor (PB-HEMT) as an embodiment of the present invention, in perspective, with portions broken away for clarity. In Fig. 4, 41 denotes a semiinsulation substrate of GaAs, and 42 denotes a heterojunction semiconductor layer grown on the substrate 41 and having a structure wherein an undoped semiconductor layer 42C of i-GaAs having a thickness of less than 100 Å(10 nm) is sandwiched between two doped semiconductor layers 42A and 42B of n-AlGaAs. Note, the electron affinity is lower in the doped semiconductor layers 42A and 42B than in the undoped semiconductor layer 42C. Otherwise, the sum of the electron affinity and an energy gap is greater in the doped layers than in the undoped layer.

Reference 43 denotes an emitter electrode; 44 denotes a collector electrode; and reference 45 denotes one of a plurality of base electrodes. Base electrodes 45 are arranged midway between the emitter and collector electrodes, at a predetermined spacing, e.g., 1000 Å or less in the present example, and along the direction perpendicular to the direction of movement from the emitter electrode to the collector electrode. A portion of each base electrode 45 is embedded in the heterojunction semiconductor layer 42. Reference 46 denotes an insulation layer for insulating the electrodes, and reference 47 denotes a common base electrode, which electrically interconnects the plurality of base electrodes 45 to keep them at an equal potential and, accordingly, reduces the base resistance as a transistor.

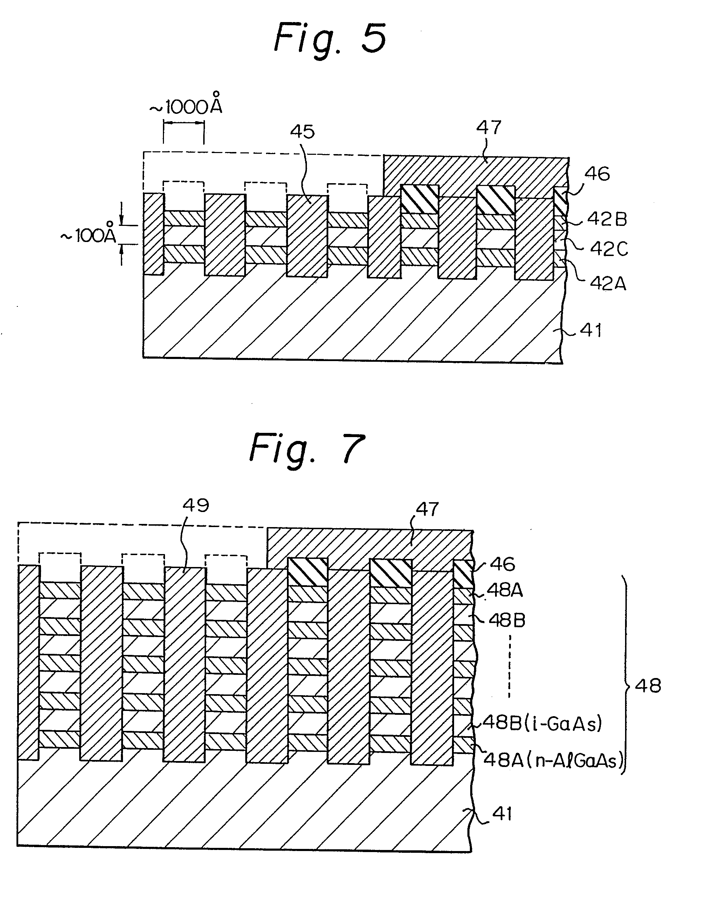

Figure 5 shows a section taken along the line A-A in Fig. 4. As shown in Fig. 5, the thickness of the intrinsic semiconductor layer 42C is very small (100 Å(10 nm) or less), and the length in the direction of the width of the laye 42C is separated into small widths of less than 1000 Å(100 nm) by the base electrodes 45 having a comb-like shape. Thus, the intrinsic semiconductor layer 42C constitutes channels defined as a one-dimensional direction, i.e., a one-dimensional electron layer or gas (1 DEG). Electrons move through the channels from the emitter electrode 43 (not shown in Fig. 5) to the collector electrode 44 (not shown in Fig. 5).

Thus, according to the structure as shown in Figs. 4 and 5, a higher electron mobility can be realized, because the direction of movement of the electrons is one-dimensional in the vicinity of the base electrodes 45. Also, since each of the base electrodes 45 is in direct contact with the heterojunction semiconductor layer 42, the controllability as a transistor can be improved.

Furthermore, since the present device constitutes a PBT having a "horizontal type" structure, the advantage as hereinafter described is obtained. Namely, according to the production process of the device shown in Fig. 4, which will be explained later in detail, it is not necessary to expose the semiconductor layers to an open atmosphere during the process of growing the semiconductor layers in the vacuum atmosphere, and as a result, it is possible to solve the problem occurring in the "vertical type" PBT of impurities remaining in the semiconductor layers due to a process such as metal deposition during the forming of the base electrode. This advantage contributes to a further acceleration of a high speed operation.

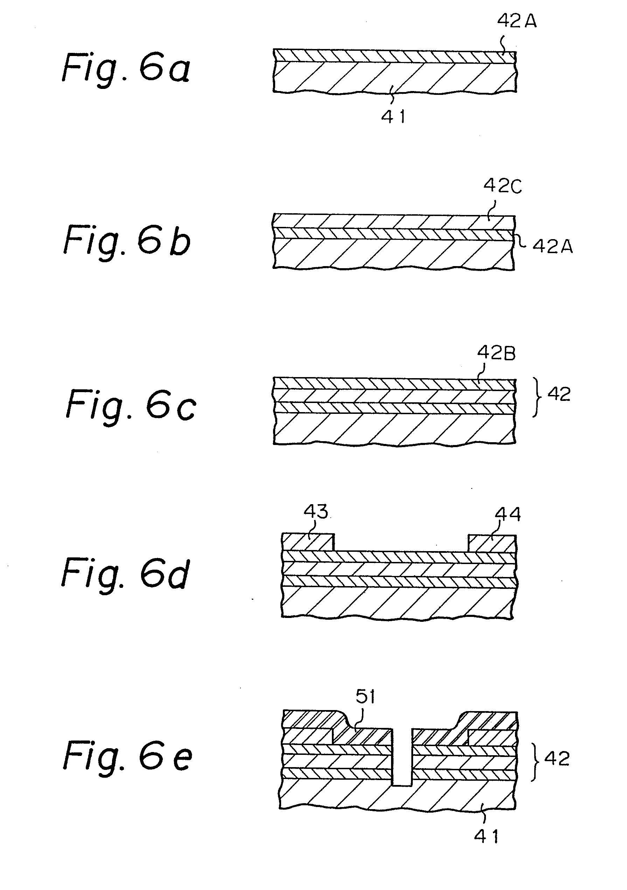

Next, a production process of the PB-HEMT shown in Fig. 4 will be described in detail with reference to Figs. 6a to 6i.

In a first step (see Fig. 6a), Si-doped AlGaAs is grown by molecular beam epitaxy (MBE) on the semiinsulation substrate 41 of GaAs to form the semiconductor layer 42A of n-AlGaAs. In a second step (see Fig. 6b), undoped GaAs is grown by MBE to form the intrinsic semiconductor layer 42C of i-GaAs, having a thickness of 100 Å(10 nm) or less. Note the thickness must be such that the movement of electrons in the vertical direction is brought to quantization. In a third step (see Fig. 6c), Si-doped AlGaAs is grown MBE to form the semiconductor layer 42B of n-AlGaAs. Thus, in the first to third steps, the heterojunction semiconductor layer 42 is formed on the substrate 41.

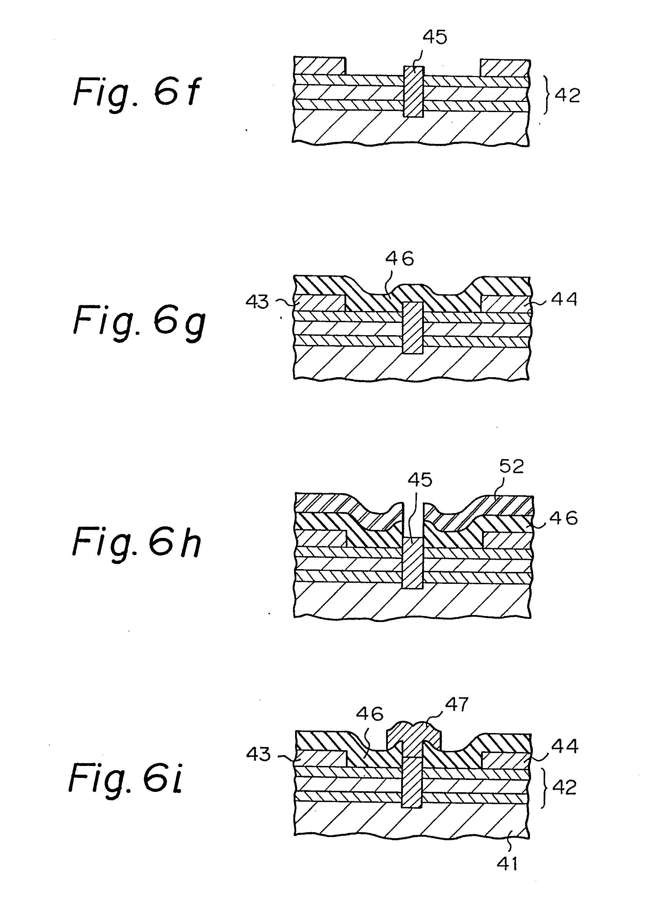

In a fourth step (see Fig. 6d), metal is deposited at predetermined portions on the heterojunction semiconductor layer to form the emitter electrode 43 and collector electrode 44. In a fifth step (see Fig. 6e), patterning for the forming of the base electrodes is carried out and a resist 51 is then formed. Next, dry etching is carried out to a depth reaching the substrate 41, to form a plurality of recess portions in which a corresponding plurality of base electrodes are embedded. In a sixth step (see Fig. 6f), the resist is removed by lift-off and the base electrodes 45 are formed.

In a seventh step (see Fig. 6g), SiO₂ or Si₃N₄ is deposited to form the insulation layer 46 for insulating each electrode, and in an eighth step (see Fig. 6h), patterning for the forming of the. common base electrode is carried out and a resist 52 is then formed. Next, dry etching is carried out to a depth reaching the base electrodes 45, and in the final step (see Fig. 6i), the resist is removed by lift-off and metal is then deposited and forms the common base electrode 47.

Although, in the above described embodiment, the device having a single 1 DEGs, i.e., intrinsic semiconductor layer, is explained, a device having a plurality of 1 DEGs may be embodied as shown in Fig. 7.

Figure 7 illustrates a section, corresponding to the section shown in Fig. 5, of a modification of the PB-HEMT shown in Fig. 4. According to the structure of the device shown in Fig. 7, a plurality of one-dimensional electron layers (1 DEGs) are formed as a multi-layer structure. In Fig. 7, the heterojunction semiconductor layer 48 has a structure wherein a plurality of semiconductor layers 48A of n-AlGaAs and a plurality of semiconductor layers 48B of i-GaAs are deposited in turn so that heterojunction structures are formed. In this state, the intrinsic semiconductor layers 48B constitute 2 DEGs. By embedding a plurality of base electrodes 49 in the heterojunction semiconductor layer 48 in such a manner that the length in the direction of width of the intrinsic semiconductor layers 48B is separated into several small width portions, multi-channel type 1 DEGs can be realized.

Also, although in the production process shown in Figs. 6a to 6i, the emitter and collector electrodes are formed (see Fig. 6d) prior to the forming of the base electrode (see Fig. 6f), this process sequence may be reversed.

Although the present invention has been disclosed and described by way of only one embodiment, it is apparent to those skilled in the art that other embodiments and modifications of the present invention are possible without departing from the spirit or essential features thereof.

## Claims

1. A semiconductor device comprising:

a heterojunction semiconductor layer (42, 48) formed on a substrate (41), having a structure including an undoped semiconductor layer (42C, 48B) sandwiched between doped semiconductor layers (42A, 42B; 48A);

two electrodes (43, 44) formed opposite to each other on said heterojunction semiconductor layer; and

a plurality of control electrodes (45, 49) arranged at predetermined positions between said two electrodes at a predetermined spacing, a portion of each control electrode being embedded in such a manner that said portion is in direct contact with a section of said heterojunction semiconductor layer, whereby the direction of the movement of carriers within said undoped semiconductor layer is made one-dimensional in the vicinity of said control electrodes.

2. A device as set forth in claim 1, further comprising a common electrode (47) for interconnecting other portions, which are not embedded in said heterojunction semiconductor layer, of said plurality of control electrodes.

3. A device as set forth in claim 1 or 2, wherein said heterojunction semiconductor layer (42) is constituted by a single undoped semiconductor layer (42C) and two doped semiconductor layers (42A, 42B) sandwiching said undoped semiconductor layer therebetween.

4. A device as set forth in claim 3, wherein an electron affinity is lower in said doped semiconductor layers (42A, 42B) than in said undoped semiconductor layer (42C).

5. A device as set forth in claim 3, wherein the sum of an electron affinity and an energy gap is greater in said doped semiconductor layers (42A, 42B) than in said undoped semiconductor layer (42C).

6. A device as set forth in claim 1 or 2, wherein said heterojunction semiconductor layer (48) has a multi-layer structure wherein a plurality of doped semiconductor layers (48A) and a plurality of undoped semiconductor layers (48B) are deposited alternately.

7. A device as set forth in claim 6, wherein an electron affinity is lower in said doped semiconductor layers (48A) than in said undoped semiconductor layers (48B).

8. A device as set forth in claim 6, wherein the sum of an electron affinity and an energy gap is greater in said doped semiconductor layers (48A) than in said undoped semiconductor layers (48B).

9. A device as set forth in any preceding claim, wherein said carriers within said undoped semiconductor layer travel through a gap defined by said predetermined spacing in a one-dimensional direction.

10. A device as set forth in claim 9, wherein said gap is 1000 Å or less, and the thickness of said undoped semiconductor layer is 100 Å or less.

11. A method for producing a semiconductor device comprising the steps of:

growing a heterojunction semiconductor layer on a substrate, said heterojunction semiconductor layer comprising a structure including an undoped semiconductor layer (42C, 48B) sandwiched between doped semiconductor layers (42A, 42B; 48A);

forming two electrodes opposite to each other on said heterojunction semiconductor layer; and

embedding a plurality of control electrodes at predetermined positions between said two electrodes at a predetermined spacing in such a manner that a portion of each control electrode is in direct contact with a section of said heterojunction semiconductor layer, whereby the direction of movement of the carriers is made one-dimensional in the vicinity of said control electrodes.

12. A method as set forth in claim 11, further comprising a step of forming a common electrode so that said plurality of control electrodes are connected thereto.

13. A method as set forth in claim 11 or 12, wherein the step of growing said heterojunction semiconductor layer comprises a step of growing a first doped semiconductor layer, an undoped semiconductor layer and a second doped semiconductor layer by molecular beam epitaxy.

14. A method as set forth in claim 11 or 12, wherein the step of growing said heterojunction semiconductor layer comprises a step of growing a plurality of doped semiconductor layers and a plurality of undoped semiconductor layers alternately.

15. A method for producing a semiconductor device comprising the steps of:

growing a heterojunction semiconductor layer on a substrate, said heterojunction semiconductor layer comprising a structure including an undoped semiconductor layer (42C, 48B) sandwiched between doped semiconductor layers (42A, 42B; 48A);

embedding a plurality of control electrodes at predetermined positions at a predetermined spacing in such a manner that a portion of each control electrode is in direct contact with a section of said heterojunction semiconductor layer, whereby the direction of movement of the carriers is made one-dimensional in the vicinity of said control electrodes; and

forming two electrodes opposite to each other on either side of said plurality of control electrodes on said heterojunction semiconductor layer.

16. A method as set forth in claim 15, further comprising a step of forming a common electrode so that said plurality of control electrodes are connected thereto.

17. A method as set forth in claim 15 or 16, wherein the step of growing said heterojunction semiconductor layer comprises a step of growing a first doped semiconductor layer, an undoped semiconductor layer and a second doped semiconductor layer by molecular beam epitaxy.

18. A method as set forth in claim 15 or 16, wherein the step of growing said heterojunction semiconductor layer comprises a step of growing a plurality of doped semiconductor layers and a plurality of undoped semiconductor layers alternately.

## Fig. 1a

14 (2DEG)  B  15  13 (n-AℓGaAs)
16  17
18  n⁺  n⁺  18
12 (i-GaAs)
11
B
B

## Fig. 1b

n-AℓGaAs

GATE ELECTRODE ← → i-GaAs

2 DEG
$E_C$
$E_F$
$E$

## Fig. 2

23(p-AℓGaAs)

22(p-GaAs)

21(p-AℓGaAs)

24  25

26 (1 DEG)

## Fig. 3

37  35

34  36  33  31  32

n

n+

0283276

# Fig. 4

## Fig. 5

~1000Å

45    47    46

~100Å    42B
42C
42A

41

## Fig. 7

49    47

46
48A
48B

48

48B(i-GaAs)

48A(n-AℓGaAs)

48

41

0283276

**Fig. 6a**  42A / 41

**Fig. 6b**  42C / 42A

**Fig. 6c**  42B } 42

**Fig. 6d**  43  44

**Fig. 6e**  51  } 42 / 41

0283276

*Fig. 6 f*

*Fig. 6 g*

*Fig. 6 h*

*Fig. 6 i*